# EUROPEAN PATENT APPLICATION

(11) **EP 1 967 608 A1**
(43) Date of publication of application: **10.09.2008**
(21) Application number: 08102036.4
(22) Date of filing: 26.02.2008
(51) Int. Cl.: C23C 14/34

(54) **High density ceramic and cermet sputtering targets by microwave sintering**

(30) Priority: 01.03.2007 US 904185 P; 04.12.2007 US 950240
(71) Applicant: Heraeus, Inc., Chandler AZ 85226 (US)
(72) Inventor: Yang Fenglin, Gilbert AZ 85296 (US); Das Anirban, Chandler AZ 85225 (US); Derrington Carl, Tempe, AZ 85284 (US); Kunkel Bernd, Phoenix AZ 85048 (US)
(74) Representative: Hill, Justin John

(57) **Abstract**

A method of manufacturing sputtering targets from powder materials, comprising steps of: providing at least one raw powder material; forming the at least one raw powder material into a green body with density greater than about 40 % of theoretical maximum density; treating the green body with microwaves to form a sintered body with density greater than about 97 % of theoretical maximum density; and forming a sputtering target from the sintered body. The methodology is especially useful in the fabrication of targets comprising dielectric and cermet materials.

## Description

### CROSS-REFERENCE TO PROVISIONAL APPLICATION

This application claims priority from U.S. provisional patent application serial No. 60/904,185 filed March 1, 2007, the entire disclosure of which is incorporated herein by reference.

### FIELD OF THE DISCLOSURE

The present disclosure relates generally to sputtering targets and methodology for manufacturing same. In particular, the present disclosure relates to high density targets fabricated from powder materials and microwave sintering methodology for their manufacture.

### BACKGROUND OF THE DISCLOSURE

Sputtering targets are used for many purposes, including producing thin films of metals, metal alloys, semiconductors, ceramics, dielectrics, ferroelectrics, and cermets (metal-ceramics). In a sputtering process, a source of material (i.e., a sputter target) is bombarded with ions from a plasma, which ions dislodge or eject atoms or molecules from the surface of the sputtering target. The ejected (i.e., sputtered) atoms or molecules are deposited atop a substrate to form a thin film coating.

In the manufacture of sputter targets currently used in high-technology applications, e.g., in the manufacture of semiconductor integrated circuit (IC) devices, electronic components, electro-optical sensor devices, magnetic recording media, etc., it is desirable to produce sputter targets that provide uniform thin films, minimal particle generation during sputtering, and desired properties.

It is believed that the density and porosity of the sputter target materials facilitates the deleterious formation of particles on the surfaces of deposition substrates, because, as material is sputtered from the target, target material adjacent to or surrounding voids in the target are less tightly bound and more easily ejected from the target as chunks or large particles that ultimately deposit on the substrate surfaces. Therefore it is considered essential that the sputtering targets comprise very high density materials with no or minimal pores in order to reduce or eliminate disadvantageous particle formation during sputtering.

Current methods for achieving suitably dense sputter targets from powder materials for use in the aforementioned high-technology applications typically involve either hot pressing or cold isostatic pressing (CIP), followed by sintering of the compact at an elevated temperature. Using either of these techniques, densities of the pressed target materials is typically only about 90 % of theoretical maximum density. Further, the high sintering temperatures required by these techniques frequently result in disadvantageous formation of large grained materials which in turn result in formation of non-uniform thin films.

Another technique frequently utilized for achieving high density sputtering targets from powder materials is hot isostatic pressing (HIP), wherein powder packing densities are typically increased from the range 30 - 50 % to about 94 - 95 % of theoretical maximum density. Disadvantageously, however, due to significant shrinkage of the volume of the powder bed, the starting dimensions of the latter may not be evenly reduced by HIP, resulting in formation of hour glass-shaped billets. Cracking of oxide and ceramic billets resulting from non-uniform shrinkage is not uncommon. Also, machining of ceramic billets is difficult. Further, unevenly packed starting powder beds are readily distorted during the HIP process, especially when the radius to thickness ratio exceeds about 3.0.

In view of the foregoing, there exists a clear need for improved methodology for manufacturing improved, very high density sputtering targets with minimal or no pores, which methodology can be implemented in cost-effective manner with a wide variety of powder materials.

### SUMMARY OF THE DISCLOSURE

An advantage of the present disclosure is improved methodology for manufacturing sputtering targets.

Another advantage of the present disclosure is improved methodology for fabricating high density sputtering targets from powder materials.

Still another advantage of the present disclosure is improved methodology for manufacturing high density sputtering targets utilizing microwave sintering of powder materials.

Further advantages of the present disclosure include improved, high density sputtering targets comprising microwave sintered dielectric or cermet materials.

Yet another advantage of the present disclosure is improved, high density MgO sputtering targets fabricated by microwave sintering.

Additional advantages and other features of the present disclosure will be set forth in the description which follows and in part will become apparent to those having ordinary skill in the art upon examination of the following or may be learned from the practice of the present disclosure. the advantages of the present disclosure may be realized and obtained as particularly pointed out in the appended claims.

According to an aspect of the present disclosure, the foregoing and other advantages are obtained in part by an improved method of manufacturing a sputtering target from a powder material, comprising steps of:
(a) providing at least one raw powder material;
(b) forming the at least one raw powder material into a green body with density greater than about 40 % of theoretical maximum density;
(c) treating the green body with microwaves to form a sintered body with density greater than about 97 % of theoretical maximum density; and
(d) forming a sputtering target from the sintered body.

In accordance with embodiments of the present disclosure, step (a) comprises providing a raw powder comprising at least one dielectric material, the least one dielectric material being an oxide, nitride, carbide, titanate, silicate, or aluminate, e.g., selected from the group consisting of: MgO, HfO₂, TiO₂, ZrO₂, Al₂O₃, Ta₂O₅, Nb₂O₅, BN, TaC, BaSrTiO₃, PbZrTiO₃, HfSiO₄, ZrSiO₄, and LaAlO₃. A preferred dielectric material is MgO.

According to other embodiments of the present disclosure, step (a) comprises providing a raw powder comprising at least one cermet (metal-ceramic) material. Preferably, the at least one cermet material comprises a magnetic metal or alloy and a ceramic material, e.g., wherein the magnetic metal or alloy is selected from the group consisting of: CoCrPt, CoPt, and FePt; and the ceramic material is selected from the group consisting of: TiO₂, SiO₂, MgO, Ta₂O₅, Nb₂O₅, Al₂O₃, BN, and TaC.

Still further embodiments according to the present disclosure include those wherein step (a) comprises providing a raw powder comprising at least one material having a dielectric constant > - 2, selected from the group consisting of oxides, perovskites, carbides, nitrides, silicates, aluminates, and titanates.

According to embodiments of the present disclosure, step (b) comprises steps of: (b₁) blending and mixing the at least one raw powder material to form a homogeneously mixed powder; and (b₂) pressing the powder to form the green body. Step (b₁) optionally includes blending and mixing at least one binder material with the at least one raw powder material; and step (b₂) comprises mechanical pressing or cold isostatic pressing (CIP).

In accordance with embodiments of the present disclosure, step (c) comprises treating the green body with microwaves by a process selected from the group consisting of: directly coupled microwave heating, susceptor-coupled microwave heating, and microwave-assisted heating.

According to certain embodiments of the present disclosure, step (c) comprises directly coupled microwave heating of the green body, the green body coupling with microwaves at temperatures ranging from room temperature to elevated, sintering temperatures; whereas, according to other embodiments of the present disclosure, step (c) comprises susceptor-coupled microwave heating of the green body, wherein at least one microwave susceptor adjacent the green body is heated by absorption of microwaves and transfers heat to the green body to thereby heat the green body to elevated, sintering temperatures at which the green body couples with microwaves. In addition, step (c) may further comprise directly coupled microwave heating of the green body.

In accordance with still other embodiments of the present disclosure, step (c) comprises microwave-assisted heating of the green body, wherein at least one heating means adjacent the green body heats the green body to elevated, sintering temperatures at which the latter couples with microwaves. In addition, step (c) may further comprise directly coupled microwave heating of the green body.

Another aspect of the present disclosure is an improved sputtering target fabricated according to the above microwave sintering methodology.

Still another advantage of the present disclosure is an improved MgO sputtering target fabricated according to the above microwave sintering methodology, which target has a density about 98.8 % of theoretical maximum density, a thickness up to about 6 in., and a diameter up to about 14 in.

Additional advantages and aspects of the present disclosure will become readily apparent to those skilled in the art from the following detailed description, wherein embodiments of the present disclosure are shown and described, simply by way of illustration of the best mode contemplated for practicing the present invention. As will be described, the present disclosure is capable of other and different embodiments, and its several details are susceptible of modification in various obvious respects, all without departing from the spirit of the present disclosure. Accordingly, the drawing and description are to be regarded as illustrative in nature, and not as limitative.

### BRIEF DESCRIPTION OF THE DRAWINGS

The following detailed description of the embodiments of the present disclosure can best be understood when read in conjunction with the following drawings, in which:

FIG. 1 is a graph showing the variation of the dielectric loss tangent (*tanδ*) of MgO dielectric material as a function of temperature; and

FIG. 2 is a graph showing the variation of the dielectric loss tangent (*tanδ*) of CoCrSiO₂ cermet material as a function of temperature.

### DETAILED DESCRIPTION OF THE DISCLOSURE

The present disclosure is based upon discovery that efficient, cost-effective manufacture of very high density sputter targets can be effected by treating a powder compact (green body) of a target material with microwave energy for heating and sintering the green body to form very high density, mechanically stable materials suitable for processing into high quality, high density sputter targets.

Briefly stated, microwave heating is a method for effecting internal, or self-heating, of a material via absorption of microwave energy, wherein the energy of electromagnetic waves (microwaves) is efficiently converted into thermal energy locally. Local conversion of the microwave energy achieves rapid and homogeneous heating of the entire volume of workpieces, and does not rely upon conduction of thermal energy throughout the workpiece. According to the present disclosure, when absorption of microwave energy is utilized for sintering of target materials, e.g., ceramics, dielectrics, and cermets, fine grain sizes and homogeneous and dense microstructures are formed, thereby improving sputtering performance (including film uniformity and properties) of sputter targets fabricated therefrom. Other advantages of sputtering targets formed by use of microwave heating of green bodies of target material include improved mechanical properties, such as increased ductility and toughness resulting from presence of finer, round-edged pores, near net shape. The improved mechanical properties afforded by the present disclosure in turn lead to time and energy savings accruing from considerably reduced processing times and temperatures, as well as reduced machining time resulting from near net shape consolidation.

According to the present disclosure, an improved method of manufacturing a sputtering target from a powder material comprises steps of:
(a) providing at least one raw powder material;
(b) forming the at least one raw powder material into a green body with density greater than about 40 % of theoretical maximum density;
(c) treating the green body with microwaves to form a sintered body with density greater than about 97 % of theoretical maximum density; and
(d) forming a sputtering target from the sintered body.

As for step (a), a wide variety of materials are suitable for provision as the raw powder material according to the present methodology, and include, without limitation, dielectric and cermet materials.

Suitable dielectric materials include, without limitation, oxides, nitrides, carbides, titanates, silicates, and aluminates, e.g., MgO, HfO₂, TiO₂, ZrO₂, Al₂O₃, Ta₂O₅, Nb₂O₅, BN, TaC, BaSrTiO₃, PbZrTiO₃, HfSiO₄, ZrSiO₄, and LaAlO₃. A preferred dielectric material is MgO.

Suitable cermet (metal-ceramic) materials include, without limitation, cermets comprised of a magnetic metal or alloy and a ceramic material, e.g., a magnetic metal or alloy such as CoCrPt, CoPt, and FePt; and ceramic material such as TiO₂, SiO₂, MgO, Ta₂O₅, Nb₂O₅, Al₂O₃, BN, and TaC.

Further suitable materials according to the present disclosure include, without limitation, other oxides, perovskites, other carbides, other nitrides, other silicates, other aluminates, and other titanates, provided they have a dielectric constant > - 2.

The dielectric properties of candidate materials must be evaluated prior to treatment with microwaves according to the above methodology. In this regard, the ability of a material to absorb microwave power is directly related to how well the material will be heated upon irradiation with microwaves. If the material does not absorb microwaves, i.e., is transparent to microwaves, or if it reflects microwaves, it will not heat well upon irradiation. Electrically insulating materials, e.g., dielectrics, tend to be transparent to microwaves, whereas electrical conductors tend to reflect microwaves. Materials with properties intermediate those of insulators and conductors tend to heat well upon microwave irradiation. Materials which are insulating at room temperature frequently become more conductive at higher temperatures, thereby facilitating absorption of microwave energy. For example, alumina (Al₂O₃), which is insulating at room temperature and therefore transparent to microwaves, becomes sufficiently conductive as to absorb microwave energy at temperatures above about 1,000 °C.

According to embodiments of the present disclosure, step (b) comprises steps of: (b₁) blending and mixing the at least one raw powder material to form a homogeneously mixed powder; and (b₂) pressing the powder to form the green body. Step (b₁) optionally includes blending and mixing at least one binder material with the at least one raw powder material; and step (b₂) comprises mechanical pressing or cold isostatic pressing (CIP).

In more detail, the raw powder material(s) is (are) weighed and blended to homogeneously mix the various components. The blended powder is then formed, as by mechanical pressing or CIP into a green disk having a density > - 40 % of theoretical maximum density, which green disk is then subjected to treatment with microwave energy for sintering into a high density (i.e., > - 97 %) body.

The dielectric properties of the pressed green disk indicate how well the material couples with microwave energy for effecting heating of the disk. Measurement of the dielectric properties of the green disk determines whether microwave heating for sintering can be performed with only microwaves or if the green disk must be heated to a certain temperature by conventional heating methodology prior to treatment with microwaves.

Penetration depth of the material, indicative of the uniformity of microwave heating of the material, can also be determined from the dielectric properties of the material.

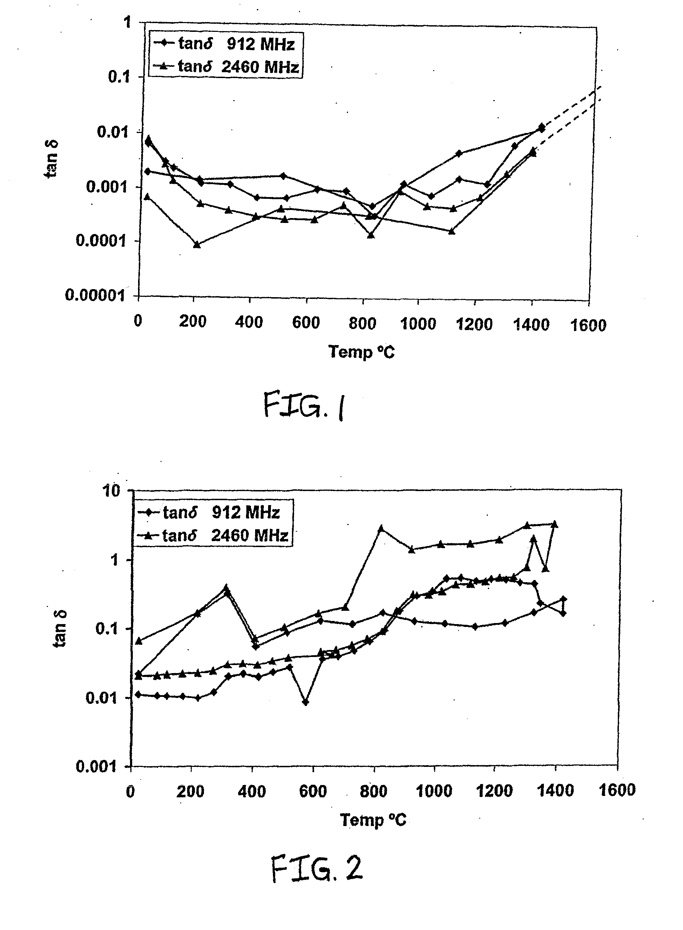

For purposes of the present disclosure, the dielectric properties of the candidate material may be measured in conventional fashion, e.g., by the cavity perturbation method, to determine the dielectric loss tangent (*tanδ*) as a function of temperature. As a rule of thumb, a *tanδ* ≥ 0.1 indicates reasonable absorption of microwave energy. For example, as shown in FIG. *1**, tanδ* vs. temperature measurements indicate that MgO dielectric material exhibits a *tanδ* ≥ 0.1 at a temperature of about 1,600 °C, and thus is capable of reasonable microwave absorption when heated to that temperature, whereas, as shown in FIG. 2, *tanδ* vs. temperature measurements indicate that CoCrSiO₂ cermet material exhibits strong self-heating in a microwave field.

Therefore, in accordance with the dielectric properties of the material of the green disk, step (c) comprises treating the green body with microwaves by directly coupled microwave heating, susceptor-coupled microwave heating, or microwave-assisted heating. More specifically, when the dielectric properties of the material of the green disk are such that microwaves are readily absorbed, step (c) comprises directly coupled microwave heating of the green body, the green body coupling with microwaves at temperatures ranging from room temperature to elevated, sintering temperatures; whereas, when *tanδ* vs. temperature measurements indicate that the material absorbs microwaves poorly at room temperature but absorption increases with temperature, step (c) comprises susceptor-coupled microwave heating of the green body, wherein at least one microwave susceptor adjacent the green body is heated by absorption of microwaves and transfers heat to the green body to thereby heat the green body to elevated, sintering temperatures at which the green body couples with microwaves. In addition, step (c) may further comprise directly coupled microwave heating of the green body.

In accordance with alternative methodology when *tanδ* vs. temperature measurements indicate that the material absorbs microwaves poorly at room temperature but absorption increases with temperature, step (c) comprises microwave-assisted heating of the green body, wherein at least one heating element adjacent the green body heats the green body to elevated, sintering temperatures at which the latter couples with microwaves. In addition, step (c) may further comprise directly coupled microwave heating of the green body. According to this embodiment, power to each of the heating elements and the microwave source can be separately regulated/controlled as desired. In addition, the green disks may be subjected to heating in a separate chamber prior to transfer to a microwave cavity for continued heating for effecting sintering.

In any instance, the resultant sintered disk formed in step (c) according to the present disclosure and having a density > - 97 % that of theoretical maximum density is then subjected in step (d) to processing, e.g., machining, etc., to form a suitably configured sputtering target. Alternatively, near net-shaped sintered bodies can be manufactured in order to simplify the machining process because only simple surface grinding and polishing are necessary for obtaining a finished target.

The utility of the present disclosure will now be illustrated with reference to the following illustrative, but non-limitative, examples.

### Example 1

MgO powder (-325 mesh, 99.99 % purity) was used for pressing 5 gm. green disks, utilizing 1" diameter uniaxial, double action dies in a 12 ton Carver press. Oleic acid [CH₃(CH₂)₇CH:CH(CH₂)₇COOH] was included in the powder mixtures of some samples to assist binding of the powder material.

The 1" diameter MgO disks were pressed at pressures up to about 12,750 psi, with and without the oleic acid binder material. Density of the pressed disks was - 1.5 gm/cm³. A pair of sample disks, i.e., one with binder and one without binder, were placed side-by-side within a heating furnace having a microwave cavity and subjected to microwave-assisted sintering in air at ambient pressure. The frequency of the microwaves was 2.45 GHz and the sample disks were subjected to heating (by other means) to 1,600 °C at a heating rate of 5 °C/min. and a dwell time of 60 min. The microwaves were applied at a power of about 1.6 - 1.8 kW when the sample disks reached a temperature of 1,600 °C and application of the microwaves continued for the balance of the 1 hr. dwell time.

The density of the green disk without binder was 40.8 % that of theoretical and the density of the sintered disk without binder was 98.8 % that of theoretical.

The density of the green disk with binder was 41.1 % that of theoretical and the average density of the sintered disks without binder was 98.9 % that of theoretical.

### Example 2

12 MgO green disks of 1" diameter were pressed at 10,200 psi without binder, each disk being scribed with an identification number before and after microwave-assisted sintering. The disks were arranged on a bed of MgO powder to cover a 5" diameter area during the sintering. The microwave-assisted sintering process comprised conventional heating of the disks to 1,550 °C at a heating rate of 5 °C/min., followed by heating to 1,600 °C at a rate of 2 °C/min. in order to avoid overshooting the desired temperature.

The density of the green disk without binder was 41.1 % that of theoretical and the average density of the sintered disks without binder was 98.6 % that of theoretical, with a standard deviation of about 0.58%.

In comparison with either of the above examples, conventional heating for the same dwell time (1 hr.) yielded sintered MgO disks with only about 93 % of theoretical maximum density. In addition, sintered MgO disks formed by microwave-assisted sintering according to the present disclosure exhibit improved microstructure, such as fine grain sizes

In summary, the microwave and microwave-assisted sintering methodology of the present disclosure affords a number of significant advantages vis-à-vis conventional techniques for the manufacture of sputtering targets via powder techniques, including increased density, reduced porosity, improved microstructure, including small grain size, and cost-effective processing.

In the previous description, numerous specific details are set forth, such as specific materials, structures, processes, etc., in order to provide a better understanding of the present invention. However, the present invention, can be practiced without resorting to the details specifically set forth herein. In other instances, well-known processing techniques and structures have not been described in order not to unnecessarily obscure the present invention.

Only the preferred embodiments of the present invention and but a few examples of its versatility are shown and described in the present disclosure. It is to be understood that the present invention is capable of use in various other combinations and environments and is susceptible of changes and/or modifications within the scope of the inventive concept as expressed herein.

## Claims

1. A method of manufacturing a sputtering target from a powder material, comprising steps of:
(a) providing at least one raw powder material;
(b) forming said at least one raw powder material into a green body with density greater than about 40 % of theoretical maximum density;
(c) treating said green body with microwaves to form a sintered body with density greater than about 97 % of theoretical maximum density; and
(d) forming a sputtering target from said sintered body.

2. The method according to claim 1, wherein:
step (a) comprises providing a raw powder comprising at least one dielectric material.

3. The method according to claim 2, wherein said at least one dielectric material is an oxide, nitride, carbide, titanate, silicate, or aluminate.

4. The method according to claim 3, wherein said at least one dielectric material is selected from the group consisting of: MgO, HfO₂, TiO₂, ZrO₂, Al₂O₃, Ta₂O₅, Nb₂O₅, BN, TaC, BaSrTiO₃, PbZrTiO₃, HfSiO₄, ZrSiO₄, and LaAlO₃.

5. The method according to claim 4, wherein said at least one dielectric material is MgO.

6. The method according to claim 1, wherein:
step (a) comprises providing a raw powder comprising at least one cermet (metal-ceramic) material.

7. The method according to claim 6, wherein:
said at least one cermet material comprises a magnetic metal or alloy and a ceramic material.

8. The method according to claim 7, wherein said magnetic metal or alloy is selected from the group consisting of: CoCrPt, CoPt, and FePt; and said ceramic material is selected from the group consisting of: TiO₂, SiO₂ MgO, Ta₂O₅, Nb₂O₅, Al₂O₃, BN, and TaC.

9. The method according to claim 1, wherein:
step (a) comprises providing a raw powder comprising at least one material having a dielectric constant > - 2, selected from the group consisting of oxides, perovskites, carbides, nitrides, silicates, aluminates, and titanates.

10. The method according to claim 1, wherein step (b) comprises steps of:
(b₁) blending and mixing said at least one raw powder material to form a homogeneously mixed powder; and
(b₂) pressing said powder to form said green body.

11. The method according to claim 10, wherein step (b₁) further includes blending and mixing at least one binder material with said at least one raw powder material.

12. The method according to claim 10, wherein:
step (b₂) comprises mechanical pressing or cold isostatic pressing (CIP).

13. The method according to claim 1, wherein:
step (c) comprises treating said green body with microwaves by a process selected from the group consisting of: directly coupled microwave heating, susceptor-coupled microwave heating, and microwave-assisted heating.

14. The method according to claim 13, wherein:
step (c) comprises directly coupled microwave heating of said green body, said green body coupling with microwaves at temperatures ranging from room temperature to elevated, sintering temperatures.

15. The method according to claim 13, wherein:
step (c) comprises susceptor-coupled microwave heating of said green body, wherein at least one microwave susceptor adjacent said green body is heated by absorption of microwaves and transfers heat to said green body to heat said green body to elevated, sintering temperatures at which said green body couples with microwaves.

16. The method according to claim 15, wherein:
step (c) further comprises directly coupled microwave heating of said green body.

17. The method according to claim 13, wherein:
step (c) comprises microwave-assisted heating of said green body, wherein at least one heating means adjacent said green body heats said green body to elevated, sintering temperatures at which said green body couples with microwaves.

18. The method according to claim 17, wherein:
step (c) further comprises directly coupled microwave heating of said green body.

19. A sputtering target fabricated according to the method of claim 1.

20. A MgO sputtering target fabricated according to the method of claim 1.

21. The MgO sputtering target of claim 20, having a density about 98.8 % of theoretical maximum density.

22. The MgO sputtering target of claim 21, having a thickness up to about 6 in. and a diameter up to about 14 in.
